# EUROPEAN PATENT SPECIFICATION

(11) **EP 0 464 696 B1**
(45) Date of publication and mention of the grant of the patent: **29.10.1997**
(21) Application number: 91110701.9
(22) Date of filing: 27.06.1991
(51) Int. Cl.: H01L 21/00, H01J 37/32, C23C 16/54

(54) **Two-step reactor chamber self cleaning process**
Zweistufiges Selbstreinigungsverfahren einer Reaktionskammer
Procédé d'auto-nettoyage en deux étapes d'une chambre de réaction

(30) Priority: 29.06.1990 US 546299
(43) Date of publication of application: 08.01.1992
(73) Proprietor: APPLIED MATERIALS, INC., Santa Clara, California 95052-8039 (US)
(72) Inventor: Cheung, David, Foster City, California 94404 (US); Keswick, Peter, Newark, California 94560 (US); Wong, Jerry, Fremont, California 94539 (US)
(74) Representative: Kahler, Kurt, Dipl.-Ing.

(56) References cited:
- EP-A- 0 266 288
- EP-A- 0 296 891
- US-A- 4 529 474
- PATENT ABSTRACTS OF JAPAN vol. 13, no. 388 (C-630)(3736) 28 August 1989, & JP-A-01 136970 (MATSUSHITA ELECTRIC IND. CO. LTD.) 30 May 1989,
- PATENT ABSTRACTS OF JAPAN vol. 13, no. 251 (E-771)(3599) 12 June 1989, & JP-A-01 050427 (HITACHI LTD.) 27 February 1989,

## Description

The invention relates to a process for self-cleaning a vacuum processing reactor according to the preamble of claim 1.

In general, the present invention relates to methods for performing single and in-situ multiple integrated circuit processing steps, including thermal CVD, plasma-enhanced chemical vapor deposition (PECVD), film etchback and reactor self-cleaning. In particular, the present invention also relates to dry process sequences for self-cleaning the reactor in-situ without disassembling the reactor or using time-consuming, wet chemical cleaning.

The reactor described herein and in the EP-A-272140 and EP-A-296891 and US-A-4,960,488 is adapted for processing very small geometry devices which are very susceptible to even small amounts of very small particulates. Although this reactor operates at relatively higher pressure than conventional reactors, it creates long-lived species which may still deposit in the exhaust system and in downstream exhaust system components to the throttle valve. Thus, although the operation of this reactor is cleaner than conventional reactors and although cleaning can be done less frequently, it is very desirable to be able to employ self-cleaning techniques to clean the reactor chamber, including the walls, and the vacuum system. The purposes include preventing contamination of particulate-sensitivity small geometry devices and ensuring long-term survival and reproducible operation of chamber and reactor hardware such as the gas inlet manifold faceplate, wafer support hardware and the throttle valve (collectively termed "hardware"). In particular, it is highly desirable to have a reactor self-cleaning process which is distinct from existing processes in that it provides effective cleaning, uses non-toxic gases, and is relatively non-corrosive of the reactor hardware.

It is the principal object of the present invention to provide a versatile and effective wafer processing reactor cleaning process. This object is achieved by a process comprising the features of claim 1. The plasma reactor self-cleaning process according to the invention may be applied insitu without disassembling or removing chamber components. It is relatively non-corrosive of the reactor hardware, and effectively cleans the reactor using non-toxic gases. Thus, the invention provides a process for cleaning a reactor chamber and its exhaust system insitu, in a single continuous process sequence of extended area etch followed by local area etch.

In one aspect, the present invention relates to a self-cleaning process for wide area cleaning of the chamber components and exhaust system components of an RF powered reactor chamber comprising communicating into the chamber via the gas manifold a gas including constituents selected from fluorocarbon gas and fluorocarbon gas doped with the reactant gas oxygen, while applying RF power to the chamber electrodes for forming an etching gas of the gas and maintaining the chamber at a pressure selected for establishing the etching plasma throughout the chamber and into the exhaust system.

In another aspect, the present invention relates to a self-cleaning process for locally cleaning the gas distribution manifold and electrodes of an RF powered reactor chamber comprising communicating into the chamber via the gas manifold a gas including constituents selected from fluorocarbon gas and fluorocarbon gas doped with the reactant gas oxygen while applying RF power to the chamber electrodes for forming an etching gas of the mixture and maintaining the chamber at a pressure sufficiently high for etching deposits from the gas manifold and electrodes.

In still another aspect, the present invention relates to the use of the above extended and local area cleaning steps in combination to provide extended and local cleaning of the chamber and exhaust.

The invention also encompasses a method of using an RF powered reactor chamber having a gas inlet manifold and a vacuum outlet system, employing self-cleaning, comprising: first, depositing or repetitively depositing a layer on a substrate positioned within the chamber; and secondly, applying the above extended area and local cleaning process.

In one specific aspect, our invention is embodied in a process for self-cleaning a vacuum processing reactor having a gas inlet manifold electrode and a wafer support electrode of variable spacing therebetween, and comprises: in a first, extended etch step, supplying a fluorocarbon-containing gas into the chamber at a first, low pressure and a first, large electrode spacing, with selected power applied between the electrodes, for generating an etching plasma substantially throughout the chamber; and, in a second, local etch step, supplying the fluorocarbon-containing gas into the chamber at a second, high pressure and a second, small electrode spacing, with selected power applied between the electrodes, for generating a local etching plasma between the electrodes the two etch steps being implemented seriation, without breaking the vacuum or changing gases. The first, extended etch step may use a C₂F6 flow rate of 300-600 sccm, O₂ flow rate 400-800 sccm, pressure 106,7 to 266,6 Pa (0.8-2 torr), electrode spacing 25,4 mm (1,000 mils) and RF power 500-750 watts ; and the second, extended etch step may use a C₂F₆ flow rate of 600-800 sccm, O₂ flow rate 700-900 sccm, pressure 800 to 1733,1 Pa (6-13 torr), electrode spacing 4,4-7,62 mm (180-300 mils) and RF power 500-750 watts . Preferably, the first, extended etch step uses the gases C₂F₆ and O₂ at a C₂F₆:O₂ flow rate ratio of (0.75-1.30):1, electrode spacing 19,05-25,4 mm (750-1,000 mils), pressure 106,7 to 266,6 Pa (0.8-2 torr) and power density 2.7-5.6 watts/cm²; and the second, local etch step uses the gases C₂F₆ and O₂ at a C₂F₆:O₂ flow rate ratio of (0.85-1):1, electrode spacing 4,4-8,9 mm (180-350 mils), pressure 800 to 1733,1 Pa (6-13 torr) and power density 2.7-5.6 watts/cm².

In still another aspect, our invention is embodied in a process for depositing dielectric coatings such as silicon oxide on semiconductor wafers in a vacuum reactor having a gas inlet manifold electrode and a wafer support electrode of variable spacing therebetween, and for self-cleaning the reactor, and comprises: depositing one or more coatings on a wafer in the chamber; and then self-cleaning the internal reactor surfaces, by, first, supplying a fluorocarbon-containing gas into the chamber at a first, low chamber pressure and a first, large electrode spacing with selected RF power applied between the electrodes, for generating an etching plasma substantially throughout the chamber; and, second, increasing the chamber pressure to a second, high value, decreasing the electrode spacing to a second, low value with selected power applied between the electrodes for generating a local etching plasma between the electrodes the two etch steps being carried out seriation, without breaking the vacuum or changing gases.

The above and other aspects and advantages of the present invention are described in conjunction with the following drawing figures, in which:
FIG. 1 is a top plan view of a combined CVD/PECVD reactor used in practicing the present invention; and
FIG. 2 depicts graphs of deposition rate vs. total deposition for both our present cleaning process and prior processing; and
FIG. 3 depicts graphs of thickness uniformity vs. total deposition for both our present cleaning process and prior processing.

### 1. Exemplary PECVD Reactor 10

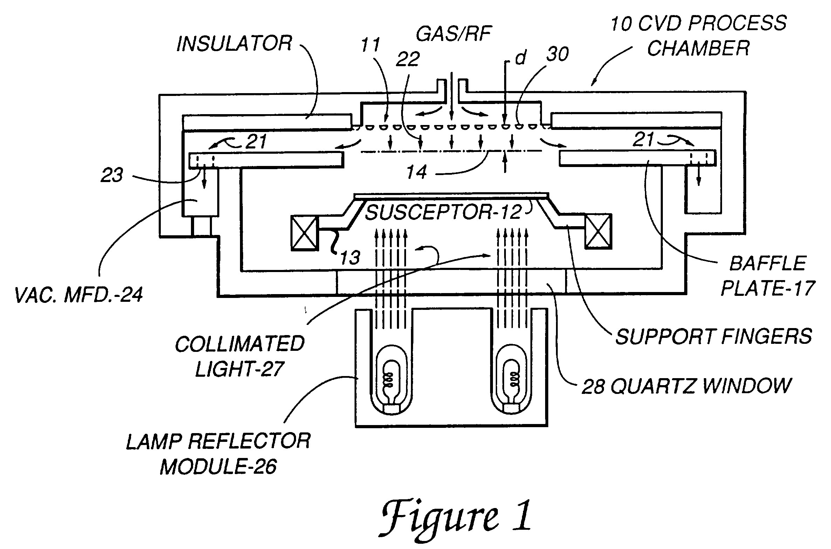

Fig. 1 schematically depicts a parallel plate CVD (chemical vapor deposition) reactor 10 which incorporates a gas inlet manifold 11 made according to the present invention. The reactor 10 is described in the aforementioned EP-A-272140 and EP-A-296891.

Reactor 10 contains a highly thermally responsive susceptor 12 which preferably is mounted on a vertically reciprocal cantilevered beam or support fingers 13 so that the susceptor 12 (and the wafer supported on the upper surface of the susceptor) can be controllably moved between a lower loading/off-loading position and an upper processing position 14 which is closely adjacent the inlet manifold 11.

When the susceptor 12 and the wafer are in the processing position 14, they are surrounded by a baffle plate 17 having a plurality of circularly spaced holes 23 which exhaust into annular vacuum manifold 24.

As a result of the high pressure capability of the reactor 10, the baffle plate 17, etc., during processing, gas inlet to the manifold along paths 22 is distributed radially uniformly along the susceptor and wafer, as indicated at 21, then is exhausted via the ports 23 into the circular vacuum manifold 24 by the vacuum pump system. A controlled plasma is formed adjacent the wafer by RF energy applied to the inlet manifold 11, which is also an RF electrode. A circular external lamp module 26 provides a collimated annular pattern 27 of light via quartz window 28 onto an annular outer peripheral portion of the susceptor 12, thereby compensating for the natural heat loss pattern of the susceptor and providing rapid and uniform susceptor and wafer heating for effecting deposition.

Typically, any or all of the gas inlet manifold faceplate, the susceptor support fingers, wafer transfer fingers (not shown) and various other reactor hardware may be made of material such as aluminum, covered with dielectric such as anodized aluminum oxide surface coating.

The variable close spacing, d, between the manifold faceplate 30 and the wafer 14 supported on susceptor 12, as well as the various other features described in detail in the referenced Wang et al patent application, including the high pressure capability, the wide pressure regime and the uniform radial gas flow, all combine to provide a wide range of processing capability to reactor 10. This processing versatility includes oxide film deposition using plasma-enhanced TEOS gas chemistry and/or ozone/TEOS gas chemistry; high rate isotropic etching; film planarization; and reactor self-cleaning.

### 2. Exemplary Silicon Oxide Deposition

A present working process for depositing silicon dioxide on 10-15 cm (four-six inch) wafers uses TEOS in helium flow rate of 250-600 sccm, oxygen 250-600 sccm, RF power 350-450 watts, electrode spacing 4,3 - 5,6 mm (170-220 mils), chamber pressure 1067 - 1333 Pa (8-10 torr) and susceptor temperature of 390-410°C (the susceptor temperature range is maintained by controlling the power to the heating lamps).

### 3. Chamber System Self-Cleaning

The present invention encompasses a localized chamber self-etch and a wide area chamber self-etch. The local etch is used to clean the RF electrodes, i.e., the susceptor 12 and the inlet gas manifold faceplate 30. The extended or wide area etch preferably cleans the entire chamber including the downstream vacuum system.

The self-cleaning process comprising the extended area etch and the local area etch steps is further characterized by the use of the same gas chemistry in both steps. Fluorocarbon gas chemistry is used and preferably, a fluorocarbon such as C₂F₆ and a reactant gas such as oxygen.

The two in-situ etch steps use the wide pressure capability and the variable close electrode spacing of the present reactor 10 in combination with the fluorocarbon gas chemistry. Specifically, the extended area etch step uses low chamber pressure, large electrode spacing, selected RF power levels applied between the electrodes 12 and 30 and selected etch gas mixture flow rates and other parameters. The process is conveniently switched to the local area etch step by increasing the pressure and decreasing the electrode spacing with adjustments as required in the associated RF power, etchant gas flow rates and other parameters. In short, the two etch steps are implemented in seriatim in the reactor without breaking vacuum or changing gases by the simple expedient of adjusting selected process parameters.

The extended area etch is used first to clean the entire chamber including the walls and hardware and then the local area step is used to clean the electrodes 12 and 30. During the extended area cleaning, the relatively thickly-coated electrodes 12 and 30 are partially cleaned; the local area etch step finishes the cleaning of the electrodes. A majority of erosion of hardware protective dielectric coatings such as anodization occurs during the low pressure extended etch step. By applying the extended area cleaning step first, the local electrodes such as the faceplate of manifold 30 are protected by the deposited oxide thereon. That oxide is then removed during the subsequent, high pressure localized etch step, with minimal erosion outside the localized region of etching.

In short, the so-called extended area first sequence has the advantage of avoiding over-etching, because the subsequent local area etch does not over-etch the previously cleaned regions outside the electrodes. In contrast, were the local etch applied first to clean the electrodes 12 and 30, the inherent chamber-wide cleaning/erosion during the subsequent low pressure extended area etch step would somewhat over-etch the unprotected local hardware such as the faceplate of the electrode 30 and the thin dielectric coatings thereon and, consequently, would diminish the lifetime of such components and the reproducible process lifetime.

Such cleaning capability is advantageous for any reactor. It is particularly advantageous for the reactor 10, which, as mentioned, is adapted for processing very small geometry devices, which are susceptible to damage caused by particulates. Although the reactor 10 operates at relatively higher pressure than conventional reactors, it nonetheless may create long-lived species which deposit in the vacuum exhaust system and in downstream vacuum system components to and including the throttle valve. Thus, while the operation of the preferred reactor 10 is cleaner than conventional reactors and while cleaning can be done less frequently, the ability to clean both the vacuum system and the reactor chamber rapidly and frequently, if necessary, is very desirable in preventing particulate contamination and in ensuring long-term proper operation of components such as the throttle valve.

The extended or wide area self-cleaning process uses a low pressure, and large electrode spacing and fluorocarbon gas chemistry for etching the entire chamber as well as the vacuum system components at a high rate. These components include, but are not limited to, in addition to the susceptor 12 and manifold 30 and related components, the window 28, the baffle flow control plate 17 and the exhaust holes 23 therein, the vacuum exhaust channel 24 and in general the components along the exhaust path at least to and including the associated throttle valve (not shown).

The localized self-cleaning step or process uses a fluorocarbon gas etch chemistry, high pressure and close spacing between the electrodes 12 and 30 (the spacing is similar to that used for deposition), to provide the desired high etch rate and stable plasma for fast local cleaning of the electrodes 12 and 30 and nearby chamber components.

In a presently preferred embodiment, for a quasi-parallel configuration for ten-twenty cm wafers, the first, extended area etch step comprises communicating the fluorocarbon, C₂F₆ and oxygen etching gas mixture into the reactor chamber at flow rates within the range of 300-600 sccm and 400-800 sccm (flow rate ratio 0.75:1), respectively, at a pressure of 106,7 to 266,6 Pa (0.8 to 2 torr), using an electrode spacing of 25,4 mm and 13.56 MHz RF power of 500-730 watts (which provides RF power density of 3.8-3.9 watts/cm²), to clean both the entire chamber and the downstream components. Optionally, NF₃ may be added at flow rates approximately 10% of the C₂F₆ flow. It should be noted that the lower pressure and the greater electrode spacing facilitates extending (in comparison to the local etch step) or spreading the cleaning plasma throughout the chamber and downstream. This step cleans chamber deposits resulting from one micrometer of silicon oxide deposition in 30-40 seconds.

In a presently preferred embodiment, also for a quasi-parallel configuration for ten-twenty cm wafers, the second, local area etch step comprises communicating a fluorocarbon and oxygen etching gas mixture into the reactor chamber at respective flow rates of 600-800 sccm and 700-900 sccm (flow rate ratio 0.85:1), at a pressure within the range 800 to 1733,1 Pa (6-13 torr), using RF power of 500-750 watts to provide an RF power density within the range of 3.8-3.9 watts/cm² at a frequency of 13.56 megahertz, and using an electrode spacing of 4,6 - 7,35 mm, to clean the chamber locally. The relatively higher pressure and the smaller electrode spacing effectively confines the cleaning plasma to the region between the electrodes 12 and 30. This step cleans local deposits resulting from one micrometer of silicon oxide deposition in 30-40 seconds.

Anticipated useful parameter ranges for a ten-twenty cm wafer configuration of the exemplary reactor 10 are, (1) for the extended area etch step: C₂F₆:O₂ flow rate ratios (0.75-1.30):1, C₂F₆ flow rate 300-1,200 sccm, O₂ flow rate 400-950 sccm, electrode spacing 22 - 25,40 mm , pressure 106,7-266,6 Pa (0.8-2 torr) and power density 2.7-5.6 watts/cm²; and (2) for the local clean step: C₂F₆:O₂ flow rate ratios of (0.85-1):1, C₂F₆ flow rate 600-950 sccm, O₂ flow rate 700-1,000 sccm, electrode spacing 4,4 - 8,9 mm (180-350 mils), pressure 800 - 1733,1 Pa (6-13 torr) and power density 2.7-5.6 watts/cm².

### 4. Summary of Certain Key Advantages

In addition to the aforementioned advantages of ease of use, extended reproducible processing lifetime and extended hardware lifetime, our process has a number of other advantages. First, the process uses relatively inexpensive process gases such as C₂F₆ and O₂. Also, the process is non-toxic, i.e., the process gases C₂F₆ and O₂ are non-toxic. Furthermore, the process is a relatively mild one in that it is relatively non-corrosive of reactor hardware.

Capital costs are decreased by at least three of the previously-mentioned factors. First, hardware lifetime is increased because the process is relatively non-corrosive to the chamber hardware. Secondly, the use of the extended area first, local area second sequence decreases over-etching of the electrodes. Thirdly, the non-toxic nature of the process reduces or eliminates the need for expensive safety monitoring equipment.

As alluded to previously, the reduced corrosion of hardware provides long-term process stability in that the processing time is increased (i.e., a greater amount of deposition is possible) before the chamber must be opened and the interior components cleaned by wet etching or the like.

In short, our process is convenient to use, easy to implement, decreases reactor downtime for maintenance and cleaning and increases hardware lifetime and processing stability lifetime.

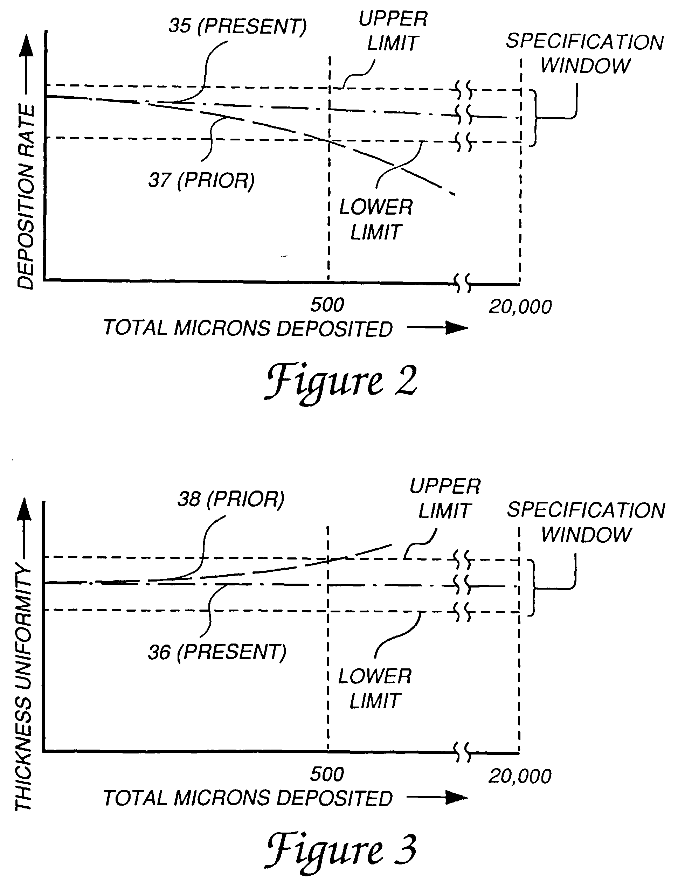

Using the above-presently preferred process parameters to self-clean the chamber 10 after every wafer deposition has extended process reproducibility lifetime, i.e., the interval between wet cleaning, to a minimum of 2 mm (2,000 microns) of deposition. Also, hardware lifetime, i.e., lifetime between maintenance or replacement, has been extended to at least 30 (30,000 microns). In comparison, previous self-cleaning processes provided deposition of 0,5 mm (500 microns) before wet cleaning and hardware lifetime of about 5 mm (5,000 microns). FIGS. 2 and 3 depict graphs 35-38 which compare the process reproducibility versus total deposition for, respectively, the present process and prior processing.

Parameters such as power and flow for the 10-20 cm (four-eight inch) wafer configurations will be readily scaled upward or downward for larger or smaller wafers. Also, we anticipate that flow rates and ratios given here can be readily adapted to other reactors.

## Claims

1. A process for self-cleaning a vacuum processing reactor having two electrodes, namely a gas inlet manifold electrode and a wafer support electrode of variable spacing therebetween, comprising:
in a first, extended etch step, supplying a fluorocarbon-containing gas into the chamber at a first, low pressure and a first, large electrode spacing, with selected power applied between the electrodes, for generating an etching plasma substantially throughout the chamber; and
in a second, local etch step, supplying the fluorocarbon-containing gas into the chamber at a second, high pressure and a second, small electrode spacing with selected power applied between the electrodes, for generating a local etching plasma between the electrodes, and wherein the two etch steps are implemented seriatim, without breaking vacuum or changing gases.

2. The process of claim 1,
wherein the first, extended etch step uses the gases C₂F₆ and O₂ at a C₂F₆:O₂ flow rate ratio of (0.75 to 1.30):1, an electrode spacing of 22 to 25.4 mm, a pressure of 106.7 to 266.6 Pa (0.8 to 2 torr) and power density of 2.7 to 5.6 watts/cm².

3. The process of claim 1 or 2,
wherein the second, local etch step uses the gases C₂F₆ and O₂ at a C₂F₆:O₂ flow rate ratio of (0.85 to 1):1, an electrode spacing of 4.6 to 7.35 mm, a pressure of 800 to 1733.1 Pa (6 to 13 torr) and a power density of 2.7 to 5.6 watts/cm².

4. The process of any of claims 1 to 3,
wherein the first, extended etch step uses C₂F₆ flow rate of 300 to 600 sccm, O₂ flow rate of 400 to 800 sccm, pressure of 106.7 to 266.6 Pa (0.8 to 2 torr), electrode spacing of 25.4 mm and RF power of 500 to 750 watts.

5. The process of any of claims 2 to 4,
wherein in the first step the C₂F₆:O₂ flow rate ratio is 0.75:1 and the RF power density is 3.8 to 3.9 watts/cm².

6. The process of any of claims 1 to 5,
wherein the second local etch step uses a C₂F₆ flow rate of 600 to 800 sccm, O₂ flow rate of 700 to 900 sccm, pressure of 800 to 1733.1 Pa (6 to 13 torr), electrode spacing of 4.6 to 7.35 mm and RF power of 500 to 750 watts.

7. The process of any of claims 1 to 6,
wherein in the second step the C₂F₆:O₂ flow rate ratio is 0.85:1 and the RF power density is 3.8 to 3.9 watts/cm².

8. A process for depositing coatings on semiconductor wafers in a vacuum reactor having a gas inlet manifold electrode and a wafer support electrode of variable spacing therebetween, and for self-cleaning the reactor,
comprising:
repetitively depositing coatings on one or more wafers in the chamber; and
applying a process for self-cleaning the internal reactor surfaces according to any of the preceding claims.

9. The process of claim 8,
wherein the first, extended etch step uses C₂F₆ flow rate of 300 to 600 sccm, O₂ flow rate of 400 to 800 sccm and RF power of 500 to 750 watts and wherein the second local etch step uses a C₂F₆ flow rate of 600 to 800 sccm, O₂ flow rate of 700 to 900 sccm and RF power of 500 to 750 watts.

## Patentansprüche

1. Ein Verfahren zum Selbstreinigen einer Vakuumbearbeitungskammer mit zwei Elektroden, nämlich einer Gaseinlaßverteilerelektrode und einer Waferstützelektrode mit verstellbarem Abstand zwischen diesen, das aufweist:
bei einem ersten, ausgedehnten Ätzschritt ein Zuführen eines Fluorkohlenstoff-haltigen Gases in die Kammer hinein bei einem ersten, niedrigen Druck und einem ersten, großen Elektrodenabstand, wobei eine ausgewählte Leistung zwischen die Elektroden angelegt wird, um ein Ätzplasma im wesentlichen in der ganzen Kammer zu erzeugen, und
bei einem zweiten, lokalen Ätzschritt ein Zuführen des Fluorkohlenstoff-haltigen Gases in die Kammer hinein bei einem zweiten, hohem Druck und einem zweiten, kleinen Elektrodenabstand, wobei eine ausgewählte Leistung zwischen die Elektroden angelegt wird, um zwischen den Elektroden ein lokales Ätzplasma zu erzeugen, und
wobei die beiden Ätzschritte nacheinander realisiert werden, ohne das Vakuum zu unterbrechen oder die Gase zu wechseln.

2. Das Verfahren nach Anspruch 1,
wobei beim ersten, ausgedehnten Ätzschritt die Gase C₂F₆ und O₂ bei einem C₂F₆:O₂-Durchflußratenverhältnis von (0,75 bis 1,3):1, ein Elektrodenabstand von 22 bis 25,4 mm, ein Druck von 106,7 bis 266,6 Pa (0,8 bis 2 Torr) und eine Leistungsdichte von 2,7 bis 5,6 Watt/cm² verwendet werden.

3. Das Verfahren nach Anspruch 1 oder 2,
wobei beim zweiten, lokalen Ätzschritt die Gase C₂F₆ und O₂ bei einem C₂F₆:O₂-Durchflußratenverhältnis von (0,85 bis 1):1, ein Elektrodenabstand von 4,6 bis 7,35 mm, ein Druck von 800 bis 1733,1 Pa (6 bis 13 Torr) und eine Leistungsdichte von 2,7 bis 5,6 Watt/cm² verwendet werden.

4. Das Verfahren nach irgendeinem der Ansprüche 1 bis 3,
wobei beim ersten, ausgedehnten Ätzschritt eine C₂F₆-Durchflußrate von 300 bis 600 sccm, eine O₂-Durchflußrate von 400 bis 800 sccm, ein Druck von 106,7 bis 266,6 Pa (0,8 bis 2 Torr), ein Elektrodenabstand von 25,4 mm und eine HF-Leistung von 500 bis 750 Watt verwendet werden.

5. Das Verfahren nach irgendeinem der Ansprüche 2 bis 4,
wobei beim ersten Schritt das C₂F₆:O₂-Durchflußratenverhältnis 0,75:1 und die HF-Leistungsdichte 3,8 bis 3,9 Watt/cm² ist.

6. Das Verfahren nach irgendeinem der Ansprüche 1 bis 5,
wobei beim zweiten, lokalen Ätzschritt eine C₂F₆-Durchflußrate von 600 bis 800 sccm, eine O₂-Durchflußrate von 700 bis 900 sccm, ein Druck von 800 bis 1733,1 Pa (6 bis 13 Torr), ein Elektrodenabstand von 4,6 bis 7,35 mm und eine HF-Leistung von 500 bis 750 Watt verwendet werden.

7. Das Verfahren nach irgendeinem der Ansprüche 1 bis 6,
wobei beim zweiten Schritt das C₂F₆:O₂-Durchflußratenverhältnis 0,85:1 und die HF-Leistungsdichte 3,8 bis 3,9 Watt/cm² ist.

8. Ein Verfahren zum Abscheiden von Beschichtungen auf Halbleiterwafern in einer Vakuumreaktionskammer mit einer Gaseinlaßverteilerelektrode und einer Waferstützelektrode mit veränderlichem Abstand zwischen diesen und zum Selbstreinigen der Reaktionskammer, das aufweist:
wiederholtes Abscheiden von Beschichtungen auf einem oder mehreren Wafern in der Kammer und
Anwenden eines Verfahrens zum Selbstreinigen der inneren Reaktionskammeroberflächen gemäß irgendeinem der vorhergehenden Ansprüche.

9. Das Verfahren nach Anspruch 8,
wobei beim ersten, ausgedehnten Ätzschritt eine C₂F₆-Durchflußrate von 300 bis 600 sccm, eine O₂-Durchflußrate von 400 bis 800 sccm und eine HF-Leistung von 500 bis 750 Watt verwendet werden und wobei beim zweiten, lokalen Ätzschritt eine C₂F₆-Durchflußrate von 600 bis 800 sccm, eine O₂-Durchflußrate von 700 bis 900 sccm und eine HF-Leistung von 500 bis 750 Watt verwendet werden.

## Revendications

1. Procédé d'auto-nettoyage d'une chambre de réaction de traitement sous vide comportant deux électrodes, à savoir une électrode de collecteur d'admission de gaz et une électrode de support de tranche présentant un espacement variable entre celles-ci, consistant à :
au cours d'une première étape de gravure étendue, appliquer un gaz contenant un hydrocarbure fluoré dans la chambre à une première basse pression, et avec un premier espacement d'électrodes important, une puissance sélectionnée étant appliquée entre les électrodes, afin de générer un plasma de gravure pratiquement dans toute la chambre, et
au cours d'une seconde étape de gravure locale, appliquer le gaz contenant un hydrocarbure fluoré dans la chambre à une seconde pression élevée, et avec un second espacement d'électrodes faible, une puissance sélectionnée étant appliquée entre les électrodes, afin de générer un plasma de gravure locale entre les électrodes, et dans laquelle les deux étapes de gravure sont réalisées successivement, sans interrompre le vide ni modifier les gaz.

2. Procédé selon la revendication 1,
dans lequel la première étape de gravure étendue utilise les gaz C₂F₆ et O₂ suivant un rapport de débit C₂F₆:O₂ de (0,75 à 1,30):1, un espacement d'électrodes de 22 à 25,4 mm, une pression de 106,7 à 266,6 Pa (0,8 à 2 torr) et une densité de puissance de 2,7 à 5,6 watts/cm²

3. Procédé selon la revendication 1 ou la revendication 2,
dans lequel la seconde étape de gravure locale utilise les gaz C₂F₆ et O₂ suivant un rapport de débit C₂F₆:O₂ de (0,85 à 1):1, un espacement d'électrode de 4,6 à 7,35 mm, une pression de 800 à 1 733,1 Pa (6 à 13 torr) et une densité de puissance de 2,7 à 5,6 watts/cm².

4. Procédé selon l'une quelconque des revendications 1 à 3,
dans lequel la première étape de gravure étendue utilise un débit de C₂F₆ de 300 à 600 sccm, un débit de O₂ de 400 à 800 sccm, une pression de 106,7 à 266,6 Pa (0,8 à 2 torr), un espacement d'électrodes de 25,4 mm et une puissance en haute fréquence de 500 à 750 watts.

5. Procédé selon l'une quelconque des revendications 2 à 4,
dans lequel au cours de la première étape, le rapport de débit C₂F₆:O₂ est de 0,75:1 et la densité de puissance en haute fréquence est de 3,8 à 3,9 watts/cm².

6. Procédé selon l'une quelconque des revendications 1 à 5,
dans lequel la seconde étape de gravure locale utilise un débit de C₂F₆ de 600 à 800 sccm, un débit de O₂ de 700 à 900 sccm, une pression de 800 à 1 733,1 Pa (6 à 13 torr), un espacement d'électrodes de 4,6 à 7,35 mm et une puissance en haute fréquence de 500 à 750 watts.

7. Procédé selon l'une quelconque des revendications 1 à 6,
dans lequel au cours de la seconde étape, le rapport de débit C₂F₆:O₂ est de 0,85:1 et la densité de puissance en haute fréquence est de 3,8 à 3,9 watts/cm².

8. Procédé destiné à déposer des revêtements sur des tranches de semiconducteur dans une chambre de réaction sous vide comportant une électrode de collecteur d'admission de gaz et une électrode de support de tranche présentant un espacement variable entre celles-ci, et destiné à auto-nettoyer la chambre de réaction, consistant à :
déposer de façon répétitive des revêtements sur une ou plusieurs tranches dans la chambre, et
appliquer un procédé d'auto-nettoyage des surfaces internes de la chambre de réaction conformément à l'une quelconque des revendications précédentes.

9. Procédé selon la revendication 8,
dans lequel la première étape de gravure étendue utilise un débit de C₂F₆ de 300 à 600 sccm, un débit de O₂ de 400 à 800 sccm et une puissance en haute fréquence de 500 à 750 watts, et dans lequel la seconde étape de gravure locale utilise un débit de C₂F₆ de 600 à 800 sccm, un débit de O₂ à 700 à 900 sccm et une puissance en haute fréquence de 500 à 750 watts.
